# EUROPEAN PATENT APPLICATION

(11) **EP 4 099 369 A1**
(43) Date of publication of application: **07.12.2022**
(21) Application number: 20924829.3
(22) Date of filing: 12.03.2020
(51) Int. Cl.: H01L 21/60, H01L 23/02

(54) **THREE-DIMENSIONAL INTEGRATED CIRCUIT, AND PROCESS AND DEVICE FOR THREE-DIMENSIONAL INTEGRATED CIRCUIT ALIGNMENT**

(71) Applicant: Huawei Technologies Co., Ltd., Shenzhen, Guangdong 518129 (CN)
(72) Inventor: XU, Jeffrey Junhao, Shenzhen, Guangdong 518129 (CN); ZHU, Weihua, Shenzhen, Guangdong 518129 (CN); ZHANG, Riqing, Shenzhen, Guangdong 518129 (CN)
(74) Representative: Isarpatent
(86) International application number: PCT/CN2020/079066
(87) International publication number: WO 2021/179270

(57) **Abstract**

This application provides a three-dimensional integrated circuit, and an alignment process and alignment device for a three-dimensional integrated circuit. The three-dimensional integrated circuit includes at least two stacked chips. The three-dimensional integrated circuit includes a first chip and a second chip that are stacked, the first chip has a first magnetic alignment mark, and the second chip has a second magnetic alignment mark. The first magnetic alignment mark and the second magnetic alignment mark are made of magnetic materials. Therefore, the first magnetic alignment mark and the second magnetic alignment mark can be magnetized in a magnetic field, and each generate a magnetic field. The first magnetic alignment mark is opposite to the second magnetic alignment mark, that is, a projection of the first magnetic alignment mark at least partially overlaps a projection of the second magnetic alignment mark on the surface that is of the first chip and that is close to the second chip. Specifically, a projection direction is perpendicular to the surface that is of the first chip and that is close to the second chip. In this solution, alignment accuracy is relatively high, and an alignment method is simple.

## Description

### TECHNICAL FIELD

This application relates to the field of semiconductor chip technologies, and in particular, to a three-dimensional integrated circuit, and an alignment process and alignment device for a three-dimensional integrated circuit.

### BACKGROUND

As a core component of many electronic devices, an integrated circuit (IC) has received great attention from the industry for its various properties. At present, with gradual reduction of a transistor feature size and an increasingly high integration degree of a chip, development of a planar (2D) integrated circuit is facing challenges. To increase a power density of an electronic device, increase a transmission speed, and reduce a signal delay, line interference, and the like, it is usually necessary to stack dies vertically to form a three-dimensional (3D) IC structure. In a process of vertically stacking the dies, an electrical connection needs to be implemented between the dies stacked together as signals usually need to be transmitted between the dies.

At present, a three-dimensional interconnection technology represented by a conductive via technology is a leading method for implementing high-density integration. To be specific, stacked chips each have a conductive via; and conductive vias of two adjacent chips need to be connected in a stacking process to implement an electrical connection of the conductive vias. As a 3D IC gradually develops towards a high density and a small size, an alignment process is one of key factors affecting an entire stacking process in a process of stacking chips using the conductive via technology. In addition, higher alignment accuracy indicates a smaller die area occupied by interconnection between the conductive vias, and saved space may be used to further improve an area of a circuit pattern.

Currently, an optical alignment method is widely used for alignment in chip stacking. In the optical alignment method, an optical mark needs to be prepared on a chip, a process is complex, and the optical mark occupies an area of a die. In addition, the mark for alignment requires a particular material and has a specific requirement on doping concentration of a silicon substrate. A complex optical device is further required to detect the optical mark to perform alignment, imposes a specific requirement on an application environment, and has high costs.

Therefore, there is an urgent need for a new alignment method that can overcome the foregoing disadvantages in the conventional technology.

### SUMMARY

This application provides a three-dimensional integrated circuit, and an alignment process and alignment device for a three-dimensional integrated circuit, to improve alignment accuracy of chip stacking for the three-dimensional integrated circuit, simplify an alignment process, and reduce costs of the alignment device.

According to a first aspect, this application provides a three-dimensional integrated circuit with a built-in magnetic alignment mark, where the three-dimensional integrated circuit is a stacked integrated circuit and includes at least two stacked chips. In a specific technical solution, the three-dimensional integrated circuit includes a first chip and a second chip that are stacked, where the first chip has a first magnetic alignment mark, and the second chip has a second magnetic alignment mark. Specifically, the first magnetic alignment mark is made of a magnetic material, and the second magnetic alignment mark is also made of a magnetic material. Therefore, the first magnetic alignment mark and the second magnetic alignment mark can be magnetized in a magnetic field and each generate a magnetic field. The first magnetic alignment mark is opposite to the second magnetic alignment mark, that is, a projection of the first magnetic alignment mark at least partially overlaps a projection of the second magnetic alignment mark on the surface that is of the first chip and that is close to the second chip. Specifically, a projection direction is perpendicular to the surface that is of the first chip and that is close to the second chip. In this solution, an alignment process is performed by using the magnetic alignment marks, materials for preparing the magnetic alignment marks are easy to obtain, costs are low, an alignment method for a three-dimensional integrated circuit is simple, and alignment accuracy of this solution is high.

The stacked chips in the three-dimensional integrated circuit need to be electrically connected to implement interconnection. To implement interconnection between the first chip and the second chip, the first chip is provided with one or more first conductive vias, and the second chip is provided with one or more second conductive vias. The first magnetic alignment mark is disposed in the one or more first conductive vias, and the second magnetic alignment mark is disposed in the one or more second conductive vias. In this solution, the first magnetic alignment mark and the second magnetic alignment mark are directly prepared in the first conductive via and the second conductive via respectively, thereby simplifying a preparation process of the first magnetic alignment mark and the second magnetic alignment mark. In addition, this does not occupy an area of the three-dimensional integrated circuit, and therefore helps improve an integration degree of the three-dimensional integrated circuit.

Forms of the magnetic alignment marks in the conductive vias are not limited. In a technical solution, the magnetic alignment marks are attached to inner walls of the conductive vias, that is, the first magnetic alignment mark is attached to the first conductive via, and the second magnetic alignment mark is attached to the second conductive via. In this solution, fewer magnetic materials are required for preparing the magnetic alignment marks, to reduce costs. In this solution, to improve a conductive effect of the conductive via, a conductive metal may be further filled in the first magnetic alignment mark. In another technical solution, the magnetic alignment marks are filled in the conductive vias, that is, the first magnetic alignment mark is filled in the first conductive via, and the second magnetic alignment mark is filled in the second conductive via. In this solution, more magnetic materials are used for the magnetic alignment marks, so that magnetic fields generated by the magnetic alignment marks after magnetization are strong, which helps improve alignment accuracy.

During specific preparation of the first magnetic alignment mark and the second magnetic alignment mark, various magnetic materials may be used. For example, the magnetic material may be a cobalt-based magnetic material, an iron-based magnetic material, or a nickel-based magnetic material, or may be a simple substance or an alloy. The cobalt-based magnetic material may be used to prepare the magnetic alignment marks, to improve magnetization intensity of the magnetic alignment marks.

According to a second aspect, based on a same inventive concept, this application further provides an alignment process for a three-dimensional integrated circuit, to align a first chip with a second chip, where the first chip has a first magnetic alignment mark, and the second chip has a second magnetic alignment mark. Specifically, the first magnetic alignment mark is made of a magnetic material, and the second magnetic alignment mark is also made of a magnetic material. Therefore, the first magnetic alignment mark and the second magnetic alignment mark can be magnetized in a magnetic field and each generate a magnetic field. The alignment process for a three-dimensional integrated circuit includes the following steps:
Step 1: Place the first chip and the second chip in a magnetic field generated by a magnet, so that the first magnetic alignment mark of the first chip is magnetized to generate a first magnetic field, and the second magnetic alignment mark of the second chip is magnetized to generate a second magnetic field. Specifically, a magnetic field intensity of the first magnetic field at a location at which the first magnetic alignment mark is located is relatively large, and a magnetic field intensity of the second magnetic field at a location at which the second magnetic alignment mark is located is relatively large. After the first magnetic field overlaps the second magnetic field, a maximum value of an intensity of a generated coupled magnetic field indicates that the first magnetic alignment mark is opposite to the second magnetic alignment mark.
Step 2: Move the first chip or the second chip based on intensities that are of the magnetic fields generated by the first magnetic alignment mark and the second magnetic alignment mark and that are monitored by a magnetic sensor, to align the first magnetic alignment mark with the second magnetic alignment mark. The magnetic sensor can monitor the magnetic field intensities. When the first chip or the second chip is moved, intensity distribution of the coupled magnetic field generated by the first magnetic field and the second magnetic field continuously changes.

In a specific manner of step 2, when the magnetic sensor detects that the intensity of the coupled magnetic field reaches a specified threshold, it may be considered that the first magnetic alignment mark is aligned with the second magnetic alignment mark. In this case, the first chip or the second chip may be stopped from moving, to implement alignment of the first chip with the second chip.

In another specific manner of step 2, the first chip or the second chip may be moved in a first direction. As the first chip or the second chip moves, when the magnetic sensor detects, at a first location, that the intensity of the coupled magnetic field is greater than or equal to a specified threshold, the first chip or the second chip is continuously moved in the first direction. When the magnetic sensor detects, at a second location, that the intensity of the coupled magnetic field is greater than or equal to the specified threshold, the first chip or the second chip is moved to a third location, and then is stopped from moving. Specifically, a distance between the third location and the first location in the first direction is equal to a distance between the third location and the second location in the first direction. In other words, the third location is in an area right between the first location and the second location.

In the step 1, the first chip and the second chip are placed in the magnetic field generated by the magnet, so that the first magnetic alignment mark and the second magnetic alignment mark are magnetized. A specific step is not limited. In one process, the first chip and the second chip may be placed in the magnetic field at the same time, so that the process is a simple process. Alternatively, step 1 includes the following two steps:
placing the first chip in the magnetic field generated by the magnet, so that the first magnetic alignment mark is magnetized, to generate the first magnetic field; and
placing the second chip in the magnetic field generated by the magnet, so that the second magnetic alignment mark is magnetized, to generate the second magnetic field.

Specifically, the step of placing the first chip and the second chip may be selected according to an actual process requirement.

In addition, in the technical solution of this application, the first chip may be a die, or the first chip may be a wafer; the second chip may also be a die, or the second chip may be a wafer. In other words, the alignment process for a three-dimensional integrated circuit in this application may align a die with another die, align a die with a wafer, or align a wafer with another wafer.

In a specific technical solution, the first chip is provided with one or more first conductive vias, and the second chip is provided with one or more second conductive vias. The first magnetic alignment mark is disposed in the one or more first conductive vias, and the second magnetic alignment mark is disposed in the one or more second conductive vias. In this solution, the first magnetic alignment mark and the second magnetic alignment mark are directly prepared in the first conductive via and the second conductive via respectively, thereby simplifying a preparation process of the first magnetic alignment mark and the second magnetic alignment mark. In addition, this does not occupy an area of the three-dimensional integrated circuit, and therefore helps improve an integration degree of the three-dimensional integrated circuit.

Forms of the magnetic alignment marks in the conductive vias are not limited. In a technical solution, the magnetic alignment marks are attached to inner walls of the conductive vias, that is, the first magnetic alignment mark is attached to the first conductive via, and the second magnetic alignment mark is attached to the second conductive via. In this solution, fewer magnetic materials are required for preparing the magnetic alignment marks, to reduce costs. In this solution, to improve a conductive effect of the conductive via, a conductive metal may be further filled in the first magnetic alignment mark. In another technical solution, the magnetic alignment marks are filled in the conductive vias, that is, the first magnetic alignment mark is filled in the first conductive via, and the second magnetic alignment mark is filled in the second conductive via. In this solution, more magnetic materials are used for the magnetic alignment marks, so that magnetic fields generated by the magnetic alignment marks after magnetization are strong, which helps improve alignment accuracy.

According to a third aspect, based on a same inventive concept, this application further provides an alignment device for a three-dimensional integrated circuit. The alignment device for a three-dimensional integrated circuit may be applied to the foregoing alignment process for a three-dimensional integrated circuit, and is configured to align a first chip with a second chip. The first chip has a first magnetic alignment mark, and the second chip has a second magnetic alignment mark. Specifically, the first magnetic alignment mark is made of a magnetic material, and the second magnetic alignment mark is also made of a magnetic material. Therefore, the first magnetic alignment mark and the second magnetic alignment mark can be magnetized in a magnetic field and each generate a magnetic field. The alignment device for a three-dimensional integrated circuit specifically includes a magnet, a magnetic sensor, a driving component, and a controller. The magnet is used to generate a magnetic field to magnetize the first magnetic alignment mark and the second magnetic alignment mark. A sensing area of the magnetic sensor is opposite to the magnetic field and is used to monitor the magnetic fields generated by the first magnetic alignment mark and the second magnetic alignment mark. The driving component is configured to drive the first chip or the second chip to move. The controller is electrically connected to the magnetic sensor and the driving component, and is configured to control, based on an intensity that is of a coupled magnetic field generated by the first magnetic alignment mark and the second magnetic alignment mark and that is detected by the magnetic sensor, the driving component to move the first chip or the second chip to align the first magnetic alignment mark with the second magnetic alignment mark. In this solution, the alignment device for a three-dimensional integrated circuit is used to implement alignment for the three-dimensional integrated circuit. The device is simple and has high alignment accuracy.

In a specific technical solution, the controller may be configured to: after the magnetic sensor detects that the intensity of the coupled magnetic field reaches a specified threshold, determine that the first magnetic alignment mark is aligned with the second magnetic alignment mark. In this case, the driving component may be controlled to stop moving, so that alignment of the first chip with the second chip can be implemented.

In another specific technical solution, the controller may further be configured to control the driving component to move the first chip or the second chip in a first direction. As the first chip or the second chip moves, when the magnetic sensor detects, at a first location, that the intensity of the coupled magnetic field is greater than or equal to a specified threshold, the driving component is controlled to continue to move the first chip or the second chip in the first direction. When the magnetic sensor detects, at a second location, that the intensity of the coupled magnetic field is greater than or equal to the specified threshold, the driving component is controlled to continue to move the first chip or the second chip to a third location, and then is controlled to stop moving the first chip or the second chip. Specifically, a distance between the third location and the first location in the first direction is equal to a distance between the third location and the second location in the first direction. In other words, the third location is in an area right between the first location and the second location.

In a specific technical solution, the first chip is provided with one or more first conductive vias, and the second chip is provided with one or more second conductive vias. The first magnetic alignment mark is disposed in the one or more first conductive vias, and the second magnetic alignment mark is disposed in the one or more second conductive vias. In this solution, the first magnetic alignment mark and the second magnetic alignment mark are directly prepared in the first conductive via and the second conductive via respectively, thereby simplifying a preparation process of the first magnetic alignment mark and the second magnetic alignment mark. In addition, this does not occupy an area of the three-dimensional integrated circuit, and therefore helps improve an integration degree of the three-dimensional integrated circuit.

Forms of the magnetic alignment marks in the conductive vias are not limited. In a technical solution, the magnetic alignment marks are attached to inner walls of the conductive vias, that is, the first magnetic alignment mark is attached to the first conductive via, and the second magnetic alignment mark is attached to the second conductive via. In this solution, fewer magnetic materials are required for preparing the magnetic alignment marks, to reduce costs. In this solution, to improve a conductive effect of the conductive via, a conductive metal may be further filled in the first magnetic alignment mark. In another technical solution, the magnetic alignment marks are filled in the conductive vias, that is, the first magnetic alignment mark is filled in the first conductive via, and the second magnetic alignment mark is filled in the second conductive via. In this solution, more magnetic materials are used for the magnetic alignment marks, so that magnetic fields generated by the magnetic alignment marks after magnetization are strong, which helps improve alignment accuracy.

### BRIEF DESCRIPTION OF DRAWINGS

FIG. 1 is a schematic diagram of a structure of a three-dimensional integrated circuit according to an embodiment of this application;
FIG. 2 is a schematic diagram of a cross-sectional structure of a chip according to an embodiment of this application;
FIG. 3 is a schematic diagram of another cross-sectional structure of a chip according to an embodiment of this application;
FIG. 4 is a schematic diagram of a cross section of a magnetic alignment mark according to an embodiment of this application;
FIG. 5 is a schematic diagram of another cross section of a magnetic alignment mark according to an embodiment of this application;
FIG. 6 is a schematic diagram of another structure of a three-dimensional integrated circuit according to an embodiment of this application;
FIG. 7 is a flowchart of an alignment process for a three-dimensional integrated circuit according to an embodiment of this application;
FIG. 8 is a schematic diagram of a structure of an alignment process for a three-dimensional integrated circuit according to an embodiment of this application;
FIG. 9 is another flowchart of an alignment process for a three-dimensional integrated circuit according to an embodiment of this application;
FIG. 10 is a schematic diagram of another structure of an alignment process for a three-dimensional integrated circuit according to an embodiment of this application; and
FIG. 11 is a schematic diagram of a structure of an alignment device for a three-dimensional integrated circuit according to an embodiment of this application.

### Reference numerals:

1-chip; 11-first chip;
12-second chip; 2-magnetic alignment mark;
21-first magnetic alignment mark; 22-second magnetic alignment mark;
3-conductive via; 4-magnet;
5-magnetic sensor; 6-conductive metal;
7-driving component; and 8-controller.

### DESCRIPTION OF EMBODIMENTS

To make objectives, technical solutions, and advantages of this application clearer, the following further describes this application in detail with reference to the accompanying drawings.

Terms used in the following embodiments are merely intended to describe particular embodiments, but are not intended to limit this application. The terms "one", "a" and "this" of singular forms used in this specification and the appended claims of this application are also intended to include expressions such as "one or more", unless otherwise specified in the context clearly.

Reference to "one embodiment", "some embodiments", or the like described in this specification means that one or more embodiments of this application include specific characteristics, structures, or features described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

A three-dimensional integrated circuit provided in embodiments of this application may be used in various electronic devices. For example, the electronic devices may be computer systems such as a server, a desktop computer, and a notebook computer. With the development of technologies, types and functions of the electronic devices are more diversified, imposing high requirements on performance of a three-dimensional integrated circuit. To improve an integration degree of the three-dimensional integrated circuit, a three-dimensional stacked integrated circuit structure is gradually widely used. During manufacturing of a stacked three-dimensional integrated circuit, mutually stacked chips need to be electrically connected. Interconnected structures need to be aligned during a stacking process to implement an electrical connection. Therefore, a chip alignment method that has a simple process and low costs is needed.

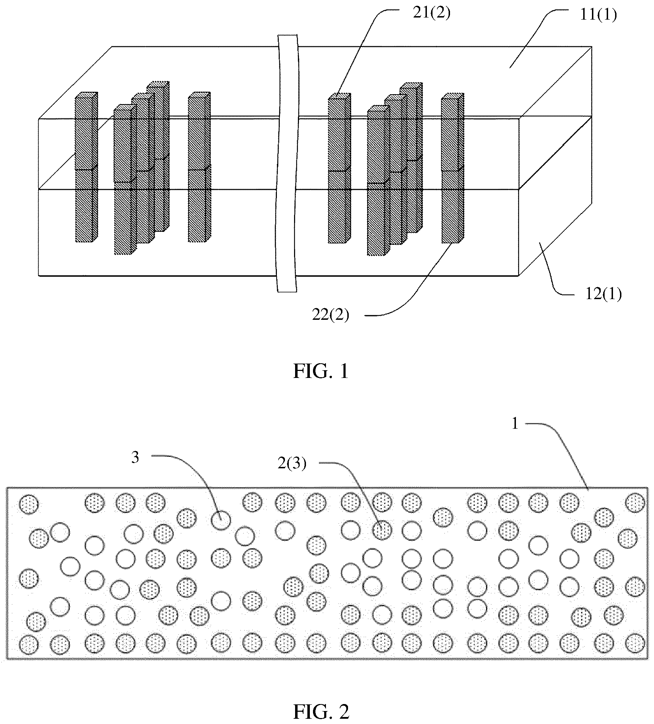

FIG. 1 is a schematic diagram of a structure of a three-dimensional integrated circuit according to an embodiment of this application. Refer to FIG. 1. The three-dimensional integrated circuit in this embodiment of this application includes at least two chips 1, where the chip 1 has a magnetic alignment mark 2. In a specific embodiment, the three-dimensional integrated circuit includes a first chip 11 and a second chip 12 that are stacked, where the first chip 11 and the second chip 12 are electrically connected to each other to implement signal transmission. The first chip 11 has a first magnetic alignment mark 21, and the second chip 12 has a second magnetic alignment mark 22. Specifically, the first magnetic alignment mark 21 and the second magnetic alignment mark 22 are made of magnetic materials, so that the first magnetic alignment mark 21 and the second magnetic alignment mark 22 can be magnetized in a magnetic field and each generate a magnetic field. This helps the first chip 11 align with the second chip 12 based on specified locations, to implement signal transmission between the first chip 11 and the second chip 12. Specifically, for projections in a direction perpendicular to the surface that is of the first chip 11 and that is adjacent to the second chip 12, a projection of the first magnetic alignment mark 21 and a projection of the second magnetic alignment mark 22 at least partially overlap. During manufacturing of the three-dimensional integrated circuit, the first chip 11 and the second chip 12 may be produced, separately. Then, an alignment device for a three-dimensional integrated circuit monitors the first magnetic alignment mark 21 and the second magnetic alignment mark 22; and when detecting that the first magnetic alignment mark 21 is opposite to the second magnetic alignment mark 22, the alignment device for a three-dimensional integrated circuit determines that the first chip 11 is aligned with the second chip 12. In this case, a subsequent bonding and interconnection process of the first chip 11 and the second chip 12 is performed. In this solution, an alignment process is performed by using the magnetic alignment mark 2, where a material for preparing the magnetic alignment mark 2 is easy to obtain. In addition, the solution does not need to rely on an optical system, the three-dimensional integrated circuit alignment method is simple, and alignment accuracy of this solution is high.

In a specific technical solution, a specific shape of the magnetic alignment mark is not specifically limited. For example, the mark may be in a shape of a sheet, a square sheet, or a circular sheet. Alternatively, the mark may be of a three-dimensional structure, for example, a prism structure or a cylindrical structure.

FIG. 2 is a schematic diagram of a cross-sectional structure of a chip according to an embodiment of this application. As shown in FIG. 2, during specific implementation of the technical solution of this application, a conductive via 3 needs to be provided in the chip 1 to implement interconnection between the first chip 11 and the second chip 12 and electrically connect the first chip 11 and the second chip 12. Specifically, the first chip 11 is provided with one or more first conductive vias, and the second chip 12 is provided with one or more second conductive vias. In the three-dimensional integrated circuit, a first conductive via in the first chip 11 and a second conductive via in the second chip 12 are in communication and electrically connected. In the technical solution of this application, alignment accuracy is high, so that a cross-sectional size of the conductive via 3 can be designed to be small, which helps reduce an area occupied by the conductive via 3 in the three-dimensional integrated circuit. During disposing the first magnetic alignment mark 21 and the second magnetic alignment mark 22, the first magnetic alignment mark 21 may be disposed in the first conductive via, and the second magnetic alignment mark 22 may be disposed in the second conductive via. In this solution, a process of manufacturing the magnetic alignment mark 2 may be simplified. To be specific, a magnetic material can be disposed in the conductive via 3 in the chip 1, to form the first magnetic alignment mark 21 and the second magnetic alignment mark 22. The process for preparing the magnetic alignment mark 2 is simple, and does not occupy an additional area of the three-dimensional integrated circuit, thereby improving an integration degree of the three-dimensional integrated circuit.

During specific formation of the first conductive via and the second conductive via, the first conductive via and the second conductive via may be regular quadrangular prisms or cylinders. This is not specifically limited in this application. In addition, shapes of the first conductive via and the second conductive via may be the same or different.

In this embodiment of this application, a quantity of first magnetic alignment marks 21 of the first chip 11 is not limited, and the first chip 11 may include a plurality of first magnetic alignment marks 21. A quantity of second magnetic alignment marks 22 of the second chip 12 is not limited, and the second chip 12 may include a plurality of second magnetic alignment marks 22. In addition, the plurality of first magnetic alignment marks 21 are not located in the same straight line. In other words, the plurality of first magnetic alignment marks 21 are distributed in a planar shape. For example, when the first chip 11 includes three first magnetic alignment marks 21, connection lines of the three first magnetic alignment marks 21 form a triangle. This helps improve alignment accuracy. In a specific technical solution, the quantity of first magnetic alignment marks 21 and the quantity of second magnetic alignment marks 22 may be the same, so that the plurality of first magnetic alignment marks 21 and the plurality of second magnetic alignment marks 22 are opposite one to one. This helps improve alignment accuracy between the first chip 11 and the second chip 12.

During disposing the first magnetic alignment mark 21 in the first conductive via, the first magnetic alignment mark 21 may be disposed in each of the first conductive vias. During disposing the second magnetic alignment mark 22 in the second conductive via, the second magnetic alignment mark 22 may be disposed in each of the second conductive vias. In this solution, structures of all the first conductive vias in the first chip 11 may be the same, and structures of all the second conductive vias in the second chip 12 may be the same. The solution facilitates simplifying a manufacturing process of the chip 1. In addition, there are a large quantity of magnetic alignment marks 2, which improves alignment accuracy.

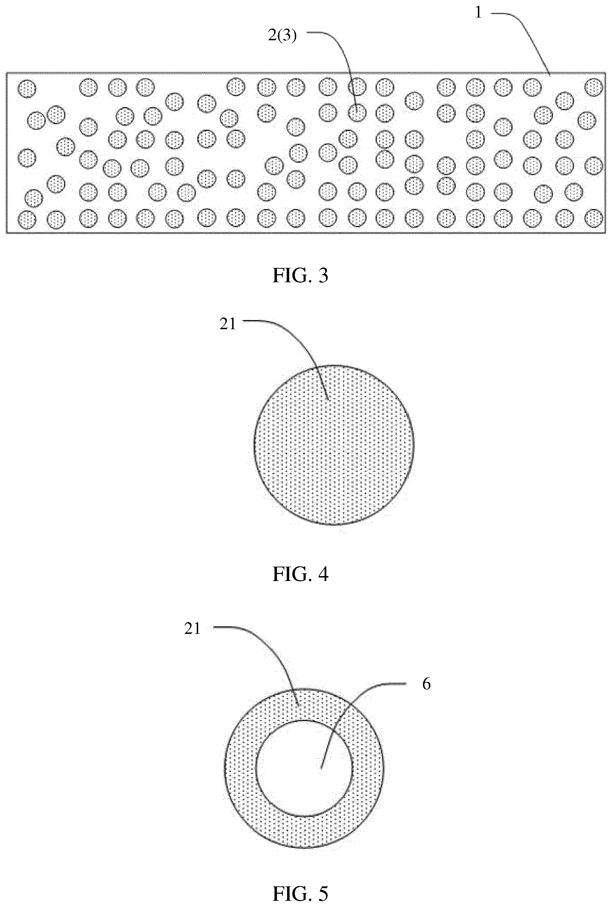

In summary, in a specific embodiment, as shown in FIG. 2, magnetic materials may be provided in some of the conductive vias 3 in the chip 1 to make the magnetic alignment marks 2. Alternatively, FIG. 3 is a schematic diagram of another cross-sectional structure of a chip according to an embodiment of this application. As shown in FIG. 3, in another specific embodiment, a magnetic material is disposed in each of the conductive vias 3 in the chip 1 to make the magnetic alignment mark.

During specific disposing of the first magnetic alignment mark 21, a specific structure of the first magnetic alignment mark 21 is not limited. FIG. 4 is a schematic diagram of a cross section of a magnetic alignment mark according to an embodiment of this application. As shown in FIG. 4, the first magnetic alignment mark 21 may be filled in the first conductive via. In this solution, the first magnetic alignment mark 21 may be further used for electrical conduction. The first magnetic alignment mark 21 is made of a large quantity of magnetic materials, and therefore generates a strong magnetic field after magnetization, which helps improve alignment accuracy. FIG. 5 is a schematic diagram of another cross section of a magnetic alignment mark according to an embodiment of this application. As shown in FIG. 5, in another technical solution, the first magnetic alignment mark 21 may be attached to an inner wall of the first conductive via, and a cross section of the first magnetic alignment mark 21 is in a ring shape. To improve a conductive effect of the first conductive via, a conductive metal 6 may further be used to fill the first magnetic alignment mark. Specifically, the conductive metal 6 may be copper with a low resistivity. In this solution, the first magnetic alignment mark 21 requires a small quantity of magnetic materials and has a low resistance.

During specific disposing of the second magnetic alignment mark 22, a specific structure of the second magnetic alignment mark 22 is not limited. As shown in FIG. 4, the second magnetic alignment mark 22 may be used to fill the second conductive via. In this solution, the second magnetic alignment mark 22 may further be used for electrical conduction. The second magnetic alignment mark 22 is made of a large quantity of magnetic materials, and therefore generates a strong magnetic field after magnetization, which helps improve alignment accuracy. As shown in FIG. 5, in another technical solution, the second magnetic alignment mark 22 may be attached to an inner wall of the second conductive via, and a cross section of the second magnetic alignment mark 22 is in a ring shape. To improve a conductive effect of the second conductive via, a conductive metal 6 may further be used to fill the second magnetic alignment mark. Specifically, the conductive metal 6 for filling may be copper with a low resistivity. In this solution, the second magnetic alignment mark 22 requires a small quantity of magnetic materials and has a low resistance.

The first magnetic alignment mark 21 and the second magnetic alignment mark 22 each are made of a magnetic material. Specifically, types of the magnetic materials are not limited. For example, the magnetic material may be a cobalt-based magnetic material, an iron-based magnetic material, or a nickel-based magnetic material, or may be a simple substance of metal, or may be an alloy. When the magnetic material is an alloy, the alloy may specifically be an iron-cobalt alloy (CoFe), a nickel-cobalt alloy (CoNi), a nickel-iron alloy (FeNi), or a nickel-iron-cobalt alloy (CoFeNi), and an appropriate magnetic material may be selected depending on a requirement. The magnetic material may be a cobalt-based magnetic material, for example, a cobalt-iron alloy, a cobalt-nickel alloy, or a cobalt-iron-nickel alloy. Because the cobalt-based magnetic material is easy to attach to a surface of silicon, there are a large quantity of first magnetic alignment marks 21 and second magnetic alignment marks 22. Further, saturation magnetization of the metallic cobalt is large. This helps improve alignment accuracy.

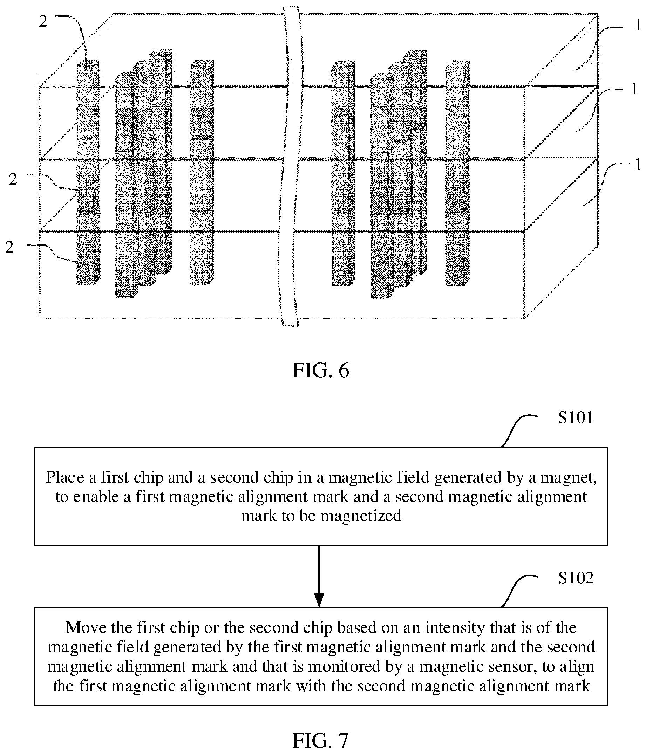

FIG. 6 is a schematic diagram of another structure of a three-dimensional integrated circuit according to an embodiment of this application. Refer to FIG. 6. In the technical solution of this application, a quantity of chips 1 included in the three-dimensional integrated circuit is not limited, and there may be two or more chips 1. When the three-dimensional integrated circuit includes a plurality of chips 1, it may be considered that one of any two adjacent chips 1 is the first chip 11 and the other chip is the second chip 12.

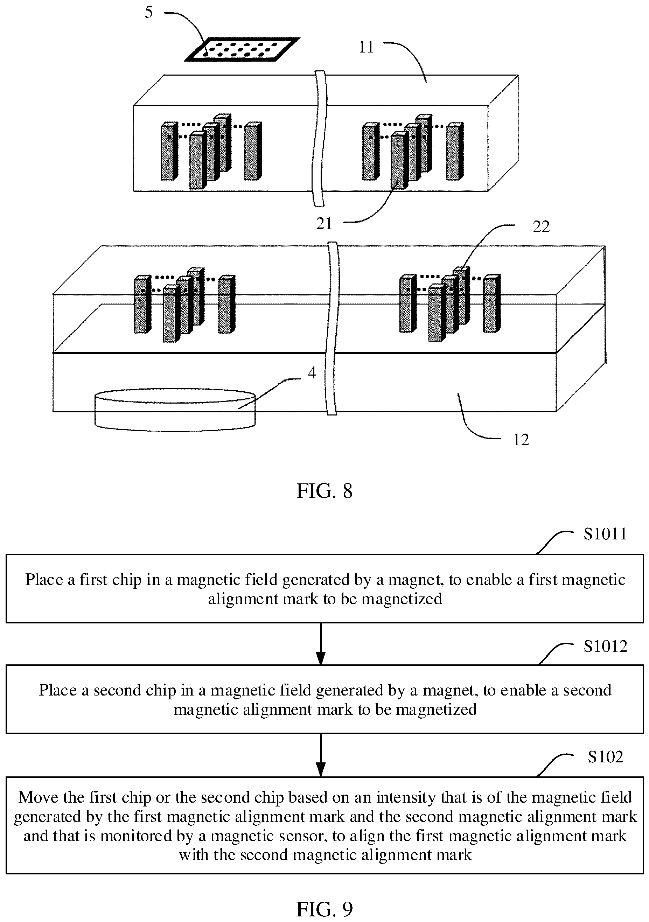

Based on a same inventive concept, this application further provides an alignment process for a three-dimensional integrated circuit, which is used to align a first chip 11 with a second chip 12. The first chip 11 has a first magnetic alignment mark 21, and the second chip 12 has a second magnetic alignment mark 22. Specifically, the first magnetic alignment mark 21 and the second magnetic alignment mark 22 are made of magnetic materials, so that the first magnetic alignment mark 21 and the second magnetic alignment mark 22 can be magnetized in a magnetic field and each generate a magnetic field. FIG. 7 is a flowchart of an alignment process for a three-dimensional integrated circuit according to an embodiment of this application. FIG. 8 is a schematic diagram of a structure of an alignment process for a three-dimensional integrated circuit according to an embodiment of this application. Refer to FIG. 7 and FIG. 8. The alignment process for a three-dimensional integrated circuit in this embodiment of this application includes the following steps:
Step S101: Place the first chip 11 and the second chip 12 in a magnetic field generated by a magnet 4, so that the first magnetic alignment mark 21 and the second magnetic alignment mark 22 are magnetized.

The magnet 4 in the alignment device for a three-dimensional integrated circuit generates a magnetic field with an intensity that can at least magnetize the first magnetic alignment mark 21 and the second magnetic alignment mark 22. In one specific embodiment, a permanent magnet may be used as the magnet 4, to reduce costs and provide a sufficient magnetic field intensity. In this solution, a driving component may be used. The driving component places the first chip 11 and the second chip 12 in the magnetic field for magnetization, so that the first magnetic alignment mark 21 generates a first magnetic field, and the second magnetic alignment mark 22 generates a second magnetic field. The first magnetic field overlaps the second magnetic field to form a coupled magnetic field.

Step S102: Move the first chip 11 or the second chip 12 based on an intensity that is of the coupled magnetic field generated by the first magnetic alignment mark 21 and the second magnetic alignment mark 22 and that is monitored by a magnetic sensor 5, to align the first magnetic alignment mark 21 with the second magnetic alignment mark 22.

The magnetic sensor 5 is used to monitor the first magnetic field and the second magnetic field, where an intensity of the first magnetic field is the largest at a location at which the first magnetic alignment mark 21 is located, and an intensity of the second magnetic field is the largest at a location at which the second magnetic alignment mark 22 is located. In this case, the coupled magnetic field formed by overlapping of the first magnetic field and the second magnetic field changes as the first chip 11 or the second chip 12 is moved.

In a specific technical solution, when the magnetic sensor 5 detects that the intensity of the coupled magnetic field reaches a specified threshold, it may be considered that the first magnetic alignment mark 21 is aligned with the second magnetic alignment mark 22. In this case, the first chip 11 or the second chip 12 may be stopped from moving. In this solution, a control process for an alignment process can be simplified by setting a threshold as a criterion. Specifically, the specified threshold may be set specific to the intensity of the coupled magnetic field generated in the specific magnetic field by the first magnetic alignment mark 21 and the second magnetic alignment mark 22 that need to be aligned, and used as a criterion. Specifically, the specified threshold may refer to a magnetic field intensity corresponding to a peak value area when the intensity of the coupled magnetic field reaches a peak value. In this solution, in a process of aligning the first magnetic alignment mark 21 with the second magnetic alignment mark 22, there is only one peak value of the intensity of the coupled magnetic field.

In another specific embodiment, during alignment of each pair of first magnetic alignment mark 21 and second magnetic alignment mark 22, there are two peak values of the intensity of the coupled magnetic field. In another specific manner of step S 102, the first chip 11 or the second chip 12 may be moved in a first direction. As the first chip 11 or the second chip 12 moves, when the magnetic sensor 5 detects, at a first location, that the intensity of the coupled magnetic field is greater than or equal to a specified threshold, the first chip 11 or the second chip 12 is continuously moved in the first direction. When the magnetic sensor 5 detects, at a second location, that the intensity of the coupled magnetic field is greater than or equal to the specified threshold, the first chip 11 or the second chip 12 is moved to a third location, and then is stopped from moving. Specifically, a distance between the third location and the first location in the first direction is equal to a distance between the third location and the second location in the first direction. In other words, the third location is in an area right between the first location and the second location. In this solution, during alignment of each pair of first magnetic alignment mark 21 and second magnetic alignment mark 22, a peak value of the intensity of the coupled magnetic field appears at the first location, and the other peak value of the intensity of the coupled magnetic field appears at the second location. Then, the first magnetic alignment mark 21 is aligned with the second magnetic alignment mark 22 at the third location in the middle of the first location and the second location.

It is worth noting that, the third location is approximately in the middle of the first location and the second location. In other words, the distance between the third location and the first location in the first direction is approximately equal to the distance between the third location and the second location in the first direction.

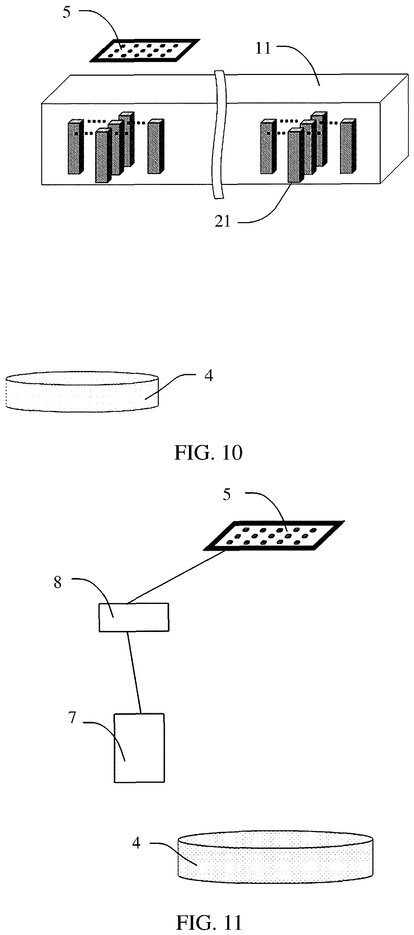

FIG. 9 is another flowchart of an alignment process for a three-dimensional integrated circuit according to an embodiment of this application. FIG. 10 is a schematic diagram of another structure of an alignment process for a three-dimensional integrated circuit according to an embodiment of this application. In a specific embodiment, reference may be made to FIG. 9, and FIG. 8 and FIG. 10. The step S101 specifically includes the following steps:
Step S1011: Place the first chip 11 in the magnetic field generated by the foregoing magnet 4, so that the first magnetic alignment mark 21 is magnetized, as shown in FIG. 10.

In this step, the first chip 11 may be placed in the magnetic field generated by the magnet 4 by using a mechanical arm, a manual operation, or the like, so that the first magnetic alignment mark 21 is magnetized, to generate a first magnetic field.

Step S1012: Place the second chip 12 in the magnetic field generated by the foregoing magnet 4, so that the second magnetic alignment mark 22 is magnetized, as shown in FIG. 8.

The second chip 12 is also placed in the magnetic field generated by the magnet 4 by using the mechanical arm or a manual operation. Specifically, the second chip 12 and the first chip 11 may be disposed in parallel, so that the second magnetic alignment mark 22 is magnetized, to generate a second magnetic field.

In a specific embodiment, the first chip 11 is located between the second chip 12 and the magnetic sensor 5. A distance between the magnetic sensor 5 and the first magnetic alignment mark 21 is not specifically limited in this application. A smaller distance between the magnetic sensor 5 and the first magnetic alignment mark 21 indicates higher alignment accuracy. Further, a smaller distance between the first chip 11 and the second chip 12 indicates higher alignment accuracy. A smaller cross section of the first magnetic alignment mark 21 and a smaller cross section of the second magnetic alignment mark 22 indicate higher alignment accuracy. A greater quantity of marks indicates higher alignment accuracy.

In another specific embodiment, the first chip 11 is located between the second chip 12 and the magnet 4. In other words, in this embodiment of this application, the first chip 11 and the second chip 12 may be placed in a direction from the magnet 4 to the magnetic sensor 5, or in a direction from the magnetic sensor 5 to the magnet 4. This is not limited in this application.

In a specific embodiment, specific forms of the first chip 11 and the second chip 12 are not limited. For example, the first chip 11 may be a die or a wafer. The second chip 12 may be a die or a wafer. Generally, a wafer includes a plurality of dies. During manufacturing of a three-dimensional integrated circuit, the wafer may be first diced to form a plurality of dies, and then an alignment and stacking process is performed. Alternatively, an alignment and stacking process may be performed on the wafer first, and then dicing is performed to form a three-dimensional integrated circuit. Therefore, the alignment process for a three-dimensional integrated circuit in this embodiment of this application may align a die to a die (die to die), a die to a wafer (die to wafer), or a wafer to a wafer (wafer to wafer). The technical solution of this application is applicable to any chip-stacking structure.

As shown in FIG. 1 and FIG. 2, during specific implementation of the technical solution of this application, a conductive via 3 needs to be provided in the chip 1. Specifically, the first chip 11 is provided with one or more first conductive vias, and the second chip 12 is provided with one or more second conductive vias. In the three-dimensional integrated circuit, a first conductive via in the first chip 11 and a second conductive via in the second chip 12 are in communication and electrically connected. In the technical solution of this application, alignment accuracy is high, so that a cross-sectional size of the conductive via 3 can be designed to be small, which helps reduce an area occupied by the conductive via 3 in the three-dimensional integrated circuit. During disposing the first magnetic alignment mark 21 and the second magnetic alignment mark 22, the first magnetic alignment mark 21 may be disposed in the first conductive via, and the second magnetic alignment mark 22 may be disposed in the second conductive via. In this solution, a process of manufacturing the magnetic alignment mark 2 may be simplified. To be specific, a magnetic material can be disposed in the conductive via 3 in the chip 1, to form the first magnetic alignment mark 21 and the second magnetic alignment mark 22. The process for preparing the magnetic alignment mark 2 is simple, and does not occupy an additional area of the three-dimensional integrated circuit, thereby improving an integration degree of the three-dimensional integrated circuit.

During specific disposing of the first magnetic alignment mark 21, a specific structure of the first magnetic alignment mark 21 is not limited. FIG. 4 is a schematic diagram of a cross section of a magnetic alignment mark according to an embodiment of this application. As shown in FIG. 4, the first magnetic alignment mark 21 may be used to fill the first conductive via. In this solution, the first magnetic alignment mark 21 may be further used for electrical conduction. The first magnetic alignment mark 21 is made of a large quantity of magnetic materials, and therefore generates a strong magnetic field after magnetization, which helps improve alignment accuracy. FIG. 5 is a schematic diagram of another cross section of a magnetic alignment mark according to an embodiment of this application. As shown in FIG. 5, in another technical solution, the first magnetic alignment mark 21 may be attached to an inner wall of the first conductive via, and a cross section of the first magnetic alignment mark 21 is in a ring shape. To improve a conductive effect of the first conductive via, a conductive metal 6 may further be used to fill the first magnetic alignment mark. Specifically, the conductive metal 6 may be copper with a low resistivity. In this solution, the first magnetic alignment mark 21 requires a small quantity of magnetic materials and has a low resistance.

During specific disposing of the second magnetic alignment mark 22, a specific structure of the second magnetic alignment mark 22 is not limited. As shown in FIG. 4, the second magnetic alignment mark 22 may be used to fill the second conductive via. In this solution, the second magnetic alignment mark 22 may further be used for electrical conduction. The second magnetic alignment mark 22 is made of a large quantity of magnetic materials, and therefore generates a strong magnetic field after magnetization, which helps improve alignment accuracy. As shown in FIG. 5, in another technical solution, the second magnetic alignment mark 22 may be attached to an inner wall of the second conductive via, and a cross section of the second magnetic alignment mark 22 is in a ring shape. To improve a conductive effect of the second conductive via, a conductive metal 6 may further be used to fill the second magnetic alignment mark. Specifically, the conductive metal 6 for filling may be copper with a low resistivity. In this solution, the second magnetic alignment mark 22 requires a small quantity of magnetic materials and has a low resistance.

The first magnetic alignment mark 21 and the second magnetic alignment mark 22 each are made of a magnetic material. Specifically, types of the magnetic materials are not limited. For example, the magnetic material may be a cobalt-based magnetic material, an iron-based magnetic material, or a nickel-based magnetic material, or may be a simple substance of metal, or may be an alloy. When the magnetic material is an alloy, the alloy may specifically be an iron-cobalt alloy (CoFe), a nickel-cobalt alloy (CoNi), a nickel-iron alloy (FeNi), or a nickel-iron-cobalt alloy (CoFeNi), and an appropriate magnetic material may be selected depending on a requirement. To improve structural stability of the first magnetic alignment mark 21 and the second magnetic alignment mark 22, a cobalt-based magnetic material, for example, a cobalt-iron alloy, a cobalt-nickel alloy, or a cobalt-iron-nickel alloy, may be used as the magnetic material. Because the cobalt-based magnetic material is easy to attach to a surface of silicon, there are a large quantity of first magnetic alignment marks 21 and second magnetic alignment marks 22. Further, saturation magnetization of the metallic cobalt is large. This helps improve alignment accuracy.

Based on a same invention concept, this application further provides an alignment device for a three-dimensional integrated circuit. FIG. 11 is a schematic diagram of a structure of the alignment device for a three-dimensional integrated circuit according to an embodiment of this application. As shown in FIG. 11, with reference to FIG. 8, the alignment device for a three-dimensional integrated circuit is configured to align a first chip 11 with a second chip 12. The first chip 11 has a first magnetic alignment mark 21, and the second chip 12 has a second magnetic alignment mark 22. Specifically, the first magnetic alignment mark 21 and the second magnetic alignment mark 22 are made of magnetic materials, so that the first magnetic alignment mark 21 and the second magnetic alignment mark 22 can be magnetized in a magnetic field and each generate a magnetic field. The alignment device for a three-dimensional integrated circuit includes a magnet 4, a magnetic sensor 5, a driving component 7, and a controller 8. In use, a sensing area of the magnet 4 is opposite to a sensing area of the magnetic sensor 5, and the first chip 11 and the second chip 12 are disposed between the magnet 4 and the sensing area of the magnetic sensor 5. The magnet 4 is used to form a magnetic field to magnetize the first magnetic alignment mark 21 and the second magnetic alignment mark 22. The magnetic sensor 5 is configured to sense an intensity of a coupled magnetic field generated by the first magnetic alignment mark 21 and the second magnetic alignment mark 22 that are magnetized. The controller 8 controls, based on a change of the intensity of the coupled magnetic field detected by the magnetic sensor 5, the driving component 7 to move the first chip 11 and the second chip 12, so as to change relative locations of the first magnetic alignment mark 21 and the second magnetic alignment mark 22. In this solution, the alignment device for a three-dimensional integrated circuit has a simple structure and low costs. In addition, using a magnetic alignment process to align the three-dimensional integrated circuit of a stacked structure has high alignment accuracy.

In a specific technical solution, when the magnetic sensor 5 detects that the intensity of the coupled magnetic field reaches a specified threshold, the controller may consider that the first magnetic alignment mark 21 is aligned with the second magnetic alignment mark 22. In this case, the controller may control the driving component 7 to stop moving the first chip 11 or the second chip 12. In this solution, a control process of the controller can be simplified by setting a threshold as a criterion. Specifically, the specified threshold may be set specific to the intensity of the coupled magnetic field generated in the specific magnetic field by the first magnetic alignment mark 21 and the second magnetic alignment mark 22 that need to be aligned, and used as a criterion. Specifically, the specified threshold may refer to a magnetic field intensity corresponding to a peak value area when the intensity of the coupled magnetic field reaches a peak value. In this solution, in a process of aligning the first magnetic alignment mark 21 with the second magnetic alignment mark 22, there is only one peak value of the intensity of the coupled magnetic field.

In another specific embodiment, in the process of aligning the first magnetic alignment mark 21 with the second magnetic alignment mark 22, there are two peak values of the intensity of the coupled magnetic field. In this case, the controller may further be configured to control the driving component 7 to move the first chip 11 or the second chip 12 in a first direction. As the first chip 11 or the second chip 12 moves, when the magnetic sensor 5 detects, at a first location, that the intensity of the coupled magnetic field is greater than or equal to a specified threshold, the driving component 7 is controlled to continue to move the first chip 11 or the second chip 12 in the first direction. When the magnetic sensor 5 detects, at a second location, that the intensity of the coupled magnetic field is greater than or equal to the specified threshold, the driving component 7 is controlled to continue to move the first chip 11 or the second chip 12 to a third location, and then is controlled to stop moving the first chip 11 or the second chip 12. Specifically, a distance between the third location and the first location in the first direction is equal to a distance between the third location and the second location in the first direction. In other words, the third location is in an area right between the first location and the second location. In this solution, during alignment of each pair of first magnetic alignment mark 21 and second magnetic alignment mark 22, a peak value of the intensity of the coupled magnetic field appears at the first location, and the other peak value of the intensity of the coupled magnetic field appears at the second location. Then, the first magnetic alignment mark 21 is aligned with the second magnetic alignment mark 22 at the third location in the middle of the first location and the second location.

It is worth noting that, the third location is approximately in the middle of the first location and the second location. In other words, the distance between the third location and the first location in the first direction is approximately equal to the distance between the third location and the second location in the first direction.

As shown in FIG. 1 and FIG. 2, during specific implementation of the technical solution of this application, a conductive via 3 needs to be provided in the chip 1. Specifically, the first chip 11 is provided with one or more first conductive vias, and the second chip 12 is provided with one or more second conductive vias. In the three-dimensional integrated circuit, a first conductive via in the first chip 11 and a second conductive via in the second chip 12 are in communication and electrically connected. In the technical solution of this application, alignment accuracy is high, so that a cross-sectional size of the conductive via 3 can be designed to be small, which helps reduce an area occupied by the conductive via 3 in the three-dimensional integrated circuit. During disposing the first magnetic alignment mark 21 and the second magnetic alignment mark 22, the first magnetic alignment mark 21 may be disposed in the first conductive via, and the second magnetic alignment mark 22 may be disposed in the second conductive via. In this solution, a process of manufacturing the magnetic alignment mark 2 may be simplified. To be specific, a magnetic material can be disposed in the conductive via 3 in the chip 1, to form the first magnetic alignment mark 21 and the second magnetic alignment mark 22. The process for preparing the magnetic alignment mark 2 is simple, and does not occupy an additional area of the three-dimensional integrated circuit, thereby improving an integration degree of the three-dimensional integrated circuit.

During specific disposing of the first magnetic alignment mark 21, a specific structure of the first magnetic alignment mark 21 is not limited. FIG. 4 is a schematic diagram of a cross section of a magnetic alignment mark according to an embodiment of this application. As shown in FIG. 4, the first magnetic alignment mark 21 may be used to fill the first conductive via. In this solution, the first magnetic alignment mark 21 may be further used for electrical conduction. The first magnetic alignment mark 21 is made of a large quantity of magnetic materials, and therefore generates a strong magnetic field after magnetization, which helps improve alignment accuracy. FIG. 5 is a schematic diagram of another cross section of a magnetic alignment mark according to an embodiment of this application. As shown in FIG. 5, in another technical solution, the first magnetic alignment mark 21 may be attached to an inner wall of the first conductive via, and a cross section of the first magnetic alignment mark 21 is in a ring shape. To improve a conductive effect of the first conductive via, a conductive metal 6 may further be used to fill the first magnetic alignment mark. Specifically, the conductive metal 6 may be copper with a low resistivity. In this solution, the first magnetic alignment mark 21 requires a small quantity of magnetic materials and has a low resistance.

During specific disposing of the second magnetic alignment mark 22, a specific structure of the second magnetic alignment mark 22 is not limited. As shown in FIG. 4, the second magnetic alignment mark 22 may be used to fill the second conductive via. In this solution, the second magnetic alignment mark 22 may further be used for electrical conduction. The second magnetic alignment mark 22 is made of a large quantity of magnetic materials, and therefore generates a strong magnetic field after magnetization, which helps improve alignment accuracy. As shown in FIG. 5, in another technical solution, the second magnetic alignment mark 22 may be attached to an inner wall of the second conductive via, and a cross section of the second magnetic alignment mark 22 is in a ring shape. To improve a conductive effect of the second conductive via, a conductive metal 6 may further be used to fill the second magnetic alignment mark. Specifically, the conductive metal 6 for filling may be copper with a low resistivity. In this solution, the second magnetic alignment mark 22 requires a small quantity of magnetic materials and has a low resistance.

The first magnetic alignment mark 21 and the second magnetic alignment mark 22 each are made of a magnetic material. Specifically, types of the magnetic materials are not limited. For example, the magnetic material may be a cobalt-based magnetic material, an iron-based magnetic material, or a nickel-based magnetic material, or may be a simple substance of metal, or may be an alloy. When the magnetic material is an alloy, the alloy may specifically be an iron-cobalt alloy (CoFe), a nickel-cobalt alloy (CoNi), a nickel-iron alloy (FeNi), or a nickel-iron-cobalt alloy (CoFeNi), and an appropriate magnetic material may be selected depending on a requirement. To improve structural stability of the first magnetic alignment mark 21 and the second magnetic alignment mark 22, a cobalt-based magnetic material, for example, a cobalt-iron alloy, a cobalt-nickel alloy, or a cobalt-iron-nickel alloy, may be used as the magnetic material. Because the cobalt-based magnetic material is easy to attach to a surface of silicon, there are a large quantity of first magnetic alignment marks 21 and second magnetic alignment marks 22. Further, saturation magnetization of the metallic cobalt is large. This helps improve alignment accuracy.

In a specific embodiment, the magnet 4 in the alignment device for a three-dimensional integrated circuit may be a permanent magnet, or may be an electromagnet. When the magnet 4 is a permanent magnet, a structure of the device is simple, costs are low, and occupied space is small. When the magnet 4 is an electromagnet, the magnetic field intensity can be adjusted based on a requirement, and the electromagnet can be disabled when not in use. A specific type of the magnet can be selected based on a requirement.

As for selection of the magnetic sensor 5, a magnetic sensor 5 with an appropriate magnetic field resolution may be selected based on a requirement. In a specific embodiment, a specific type of the magnetic sensor 5 may be a tunnel magnetoresistance sensor. When an area of a sensing area of the tunnel magnetoresistance sensor is 2×2 µm, a magnetic field resolution of the tunnel-magneto-resistance magnetic sensor may reach a magnitude of 10⁻⁸ T. The high resolution of the tunnel-magneto-resistance magnetic sensor can recognize a small change in the magnetic field intensity, and therefore improve alignment accuracy of the first magnetic alignment mark 21 and the second magnetic alignment mark 22.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1. A three-dimensional integrated circuit, comprising:
a first chip having a first magnetic alignment mark made of a magnetic material; and
a second chip having a second magnetic alignment mark made of a magnetic material, wherein
the first chip and the second chip are stacked, a projection of the first magnetic alignment mark at least partially overlaps a projection of the second magnetic alignment mark on a surface that is of the first chip and that is close to the second chip, and a direction of the projection is a direction perpendicular to the surface that is of the first chip and that is close to the second chip.

2. The three-dimensional integrated circuit according to claim 1, wherein the first chip comprises one or more first conductive vias, and the first magnetic alignment mark is disposed in the one or more first conductive vias; and the second chip comprises one or more second conductive vias, and the second magnetic alignment mark is disposed in the one or more second conductive vias.

3. The three-dimensional integrated circuit according to claim 2, wherein the first magnetic alignment mark is attached to an inner wall of the one or more first conductive vias, or the first magnetic alignment mark is filled in the one or more first conductive vias.

4. The three-dimensional integrated circuit according to claim 2 or 3, wherein the second magnetic alignment mark is attached to an inner wall of the one or more second conductive vias, or the second magnetic alignment mark is filled in the one or more second conductive vias.

5. The three-dimensional integrated circuit according to any one of claims 1 to 4, wherein the first magnetic alignment mark is made of a cobalt-based magnetic material, and the second magnetic alignment mark is made of a cobalt-based magnetic material.

6. An alignment process for a three-dimensional integrated circuit alignment process, used to align a first chip with a second chip, wherein the first chip has a first magnetic alignment mark made of a magnetic material, and the second chip has a second magnetic alignment mark made of a magnetic material; and the alignment process comprises:
placing the first chip and the second chip in a magnetic field generated by a magnet, to enable the first magnetic alignment mark and the second magnetic alignment mark to be magnetized; and
moving the first chip or the second chip based on an intensity that is of the coupled magnetic field generated by the first magnetic alignment mark and the second magnetic alignment mark and that is monitored by a magnetic sensor, to align the first magnetic alignment mark with the second magnetic alignment mark.

7. The alignment process for a three-dimensional integrated circuit alignment process according to claim 6, wherein the moving the first chip or the second chip based on an intensity that is of the coupled magnetic field generated by the first magnetic alignment mark and the second magnetic alignment mark and that is monitored by a magnetic sensor, to align the first magnetic alignment mark with the second magnetic alignment mark specifically comprises:
moving the first chip or the second chip; and when the magnetic sensor detects that the coupling magnetic field intensity is greater than or equal to a specified threshold, stopping moving the first chip or stopping moving the second chip.

8. The alignment process for a three-dimensional integrated circuit alignment process according to claim 6, wherein the moving the first chip or the second chip based on an intensity that is of the coupled magnetic field generated by the first magnetic alignment mark and the second magnetic alignment mark and that is monitored by a magnetic sensor, to align the first magnetic alignment mark with the second magnetic alignment mark specifically comprises:
moving the first chip or the second chip in a first direction; and when the magnetic sensor detects, at a first location, that the intensity of the coupled magnetic field is greater than or equal to a specified threshold, and detects, at a second location, that the intensity of the coupled magnetic field is greater than or equal to the specified threshold, moving the first chip or the second chip to a third location, and stopping moving the first chip or the second chip, wherein
a distance between the third location and the first location in the first direction is equal to a distance between the third location and the second location in the first direction.

9. The alignment process for a three-dimensional integrated circuit alignment process according to any one of claims 6 to 8, wherein the placing the first chip and the second chip in a magnetic field generated by a magnet, to enable the first magnetic alignment mark and the second magnetic alignment mark to be magnetized specifically comprises:
placing the first chip in the magnetic field generated by the magnet, to enable the first magnetic alignment mark to be magnetized; and
placing the second chip in the magnetic field generated by the magnet, to enable the second magnetic alignment mark to be magnetized.

10. The alignment process for a three-dimensional integrated circuit alignment process according to any one of claims 6 to 9, wherein the first chip is a die, or the first chip is a wafer; and
the second chip is a die, or the second chip is a wafer.

11. The alignment process for a three-dimensional integrated circuit alignment process according to any one of claims 6 to 10, wherein the first chip comprises one or more first conductive vias, and the first magnetic alignment mark is disposed in the one or more first conductive vias; and the second chip comprises one or more second conductive vias, and the second magnetic alignment mark is disposed in the one or more second conductive vias.

12. The alignment process for a three-dimensional integrated circuit alignment process according to claim 11, wherein the first magnetic alignment mark is attached to an inner wall of the one or more first conductive vias, or the first magnetic alignment mark is filled in the one or more first conductive vias.

13. The alignment process for a three-dimensional integrated circuit alignment process according to claim 11 or 12, wherein the second magnetic alignment mark is attached to an inner wall of the one or more second conductive vias, or the second magnetic alignment mark is filled in the one or more second conductive vias.

14. An alignment device for a three-dimensional integrated circuit, configured to align a first chip with a second chip, wherein the first chip has a first magnetic alignment mark made of a magnetic material, and the second chip has a second magnetic alignment mark made of a magnetic material; and the alignment process comprises:
a magnet, configured to generate a magnetic field;
a magnetic sensor, configured to monitor an intensity of a coupled magnetic field generated by the first magnetic alignment mark and the second magnetic alignment mark;
a driving component, configured to drive the first chip or the second chip to move; and
a controller, electrically connected to the magnetic sensor and the driving component, configured to control, based on an intensity that is of the coupled magnetic field generated by the first magnetic alignment mark and the second magnetic alignment mark and that is monitored by a magnetic sensor, the driving component to move the first chip or the second chip to align the first magnetic alignment mark with the second magnetic alignment mark.

15. The alignment device for a three-dimensional integrated circuit according to claim 14, wherein the controller is configured to: control the driving component to move the first chip or the second chip, and when the magnetic sensor detects that the intensity of the coupled magnetic field is greater than or equal to a specified threshold, control the driving component to stop moving the first chip or stop moving the second chip.

16. The alignment device for a three-dimensional integrated circuit according to claim 14, wherein the controller is configured to: controlling the driving component to move the first chip or the second chip in a first direction; and when the magnetic sensor detects, at a first location, that the intensity of the coupled magnetic field is greater than or equal to a specified threshold, and detects, at a second location, that the intensity of the coupled magnetic field is greater than or equal to the specified threshold, move the first chip or the second chip to a third location, and stop moving the first chip or the second chip, wherein
a distance between the third location and the first location in the first direction is equal to a distance between the third location and the second location in the first direction.

17. The alignment device for a three-dimensional integrated circuit according to any one of claims 14 to 16, wherein the first chip comprises one or more first conductive vias, and the first magnetic alignment mark is disposed in the one or more first conductive vias; and the second chip comprises one or more second conductive vias, and the second magnetic alignment mark is disposed in the one or more second conductive vias.

18. The alignment device for a three-dimensional integrated circuit according to claim 17, wherein the first magnetic alignment mark is attached to an inner wall of the one or more first conductive vias orient its work toward, or the first magnetic alignment mark is filled in the one or more first conductive vias.

19. The alignment device for a three-dimensional integrated circuit according to claim 17 or 18, wherein the second magnetic alignment mark is attached to an inner wall of the one or more second conductive vias, or the second magnetic alignment mark is filled in the one or more second conductive vias.
